# EUROPEAN PATENT APPLICATION

(11) **EP 1 284 500 A2**
(43) Date of publication of application: **19.02.2003**
(21) Application number: 02014072.9
(22) Date of filing: 01.07.2002
(51) Int. Cl.: H01L 21/768

(54) **Semiconductor device and method of manufacturing the same**

(30) Priority: 17.08.2001 JP 2001247936
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Ikakura, Hiroshi, c/o Canon Sales Co., Ltd., Minato-ku, Tokyo 108-0073 (JP); Suzuki, Tomomi, c/o Canon Sales Co., Inc., Minato-ku, Tokyo 108-0073 (JP); Maeda, Kazuo, Minato-ku, Tokyo 108-0075 (JP); Shioya, Yoshimi, Minato-ku, Tokyo 108-0075 (JP); Nishimoto, Yuhko, Minato-ku, Tokyo 108-0075 (JP)
(74) Representative: Schwabe - Sandmair - Marx

(57) **Abstract**

The present invention relates to a semiconductor device in which a barrier insulating film is formed to cover a wiring made of a copper film or consisting mainly of the copper film. In structure, the barrier insulating film 34a, 38a comprises a double-layered structure or more which is provided with at least a first barrier insulating film 34aa, 38aa containing silicon, oxygen, nitrogen and hydrogen or silicon, oxygen, nitrogen, hydrogen and carbon, and a second barrier insulating film 34ab, 38ab containing silicon, oxygen and hydrogen or silicon, oxygen, hydrogen and carbon.

## Description

### BACKGROUND OF THE INVENTION

### 1. Field of the Invention

The present invention relates to a semiconductor device in which a barrier insulating film is formed to cover a wiring consisting of a copper film or mainly made of the copper film on a substrate, and a method of manufacturing the same.

### 2. Description of the Prior Art

In recent years, not only the higher integration degree of the semiconductor integrated circuit device but also the higher data transfer rate is requested. For this reason, there is desired the barrier insulating film that employs the wiring consisting of the copper film or mainly made of the copper film and also has a copper diffusion preventing capability and a small relative dielectric constant.

As the barrier insulating film, either the silicon oxide film formed by the plasma CVD method using the film forming gas that contains tetramethylsilane (SiH(CH₃)₄) and CH₄ or the silicon nitride film formed by the plasma CVD method is employed.

However, there is the problem that, according to the silicon oxide film of the former, the relative dielectric constant is small but a large amount of carbon is contained and thus it is difficult to suppress sufficiently the leakage current. Also, there is the problem that the copper diffusion preventing capability of the silicon oxide film is not sufficient. In contrast, there is the problem that, according to the silicon nitride film of the latter, the leakage current is small and the diffusion preventing capability with respect to the copper is sufficiently high, but the relative dielectric constant is large.

### SUMMARY OF THE INVENTION

It is an object of the present invention to provide a semiconductor device having the barrier insulating film which covers the wiring made of the copper film or mainly consisting of the copper film, whose leakage current is small, whose copper diffusion preventing capability is sufficiently high, and whose relative dielectric constant is small, and a method of manufacturing the same.

The insulating film that contains silicon, oxygen, nitrogen, and hydrogen or silicon, oxygen, nitrogen, hydrogen, and carbon is dense, its leakage current is small, and its copper diffusion preventing capability is sufficiently higher but its relative dielectric constant is higher because such film contains the nitrogen. Also, the selective etching ratio of the insulating film to the SiO₂ film formed by the plasma CVD method is large. In contrast, in the insulating film that contains either silicon, oxygen, and hydrogen or silicon, oxygen, hydrogen, and carbon, the relative dielectric constant is lower, but the denseness is relatively lower and thus the leakage current is large. Also, the insulating film cannot put sufficient confidence in the copper diffusion preventing capability.

In the present invention, the barrier insulating film for covering the wiring made of the copper film or consisting mainly of the copper film has a double-layered structure or more constructed at least by a first barrier insulating film and a second barrier insulating film. The first barrier insulating film contains either silicon, oxygen, nitrogen, and hydrogen or silicon, oxygen, nitrogen, hydrogen, and carbon. The second barrier insulating film contains silicon, oxygen, and hydrogen or silicon, oxygen, hydrogen, and carbon. Any one of the first barrier insulating film and the second barrier insulating film may be formed of the layer that comes into contact with the wiring made of the copper film or consisting mainly of the copper film.

More particularly, in order not to spoil the functions such that the leakage current is small and the diffusion preventing capability with respect to the copper is sufficiently high, the film thickness of the first barrier insulating film that has the relatively high relative dielectric constant is set to the thin film thickness, while the film thickness of the second barrier insulating film that has the low relative dielectric constant is set to the thick film thickness that is necessary and sufficient for the overall film thickness of the barrier insulating film. As a result, the barrier insulating film composed of at least the first barrier insulating film and the second barrier insulating film has the performances such that the relative dielectric constant is low, the leakage current is small, and the copper diffusion preventing capability is sufficiently high.

The above first barrier insulating film is the insulating film that contains silicon, oxygen, nitrogen, and hydrogen. This first insulating film can be formed by plasmanizing the first film forming gas containing silane (SiH₄), at least any one of N₂O and H₂O, and at least any one of N₂ and NH₃ to react. Also, the above first barrier insulating film is the insulating film that contains silicon, oxygen, nitrogen, hydrogen, and carbon. This first insulating film can be formed by plasmanizing the first film forming gas containing at least any one of siloxane and methylsilane (SiHₙ(CH₃)₄₋ₙ:n=0, 1, 2, 3), at least any one of N₂O, H₂O and CO₂, and at least any one of N₂ and NH₃ to react.

The above second barrier insulating film is the insulating film that contains silicon, oxygen, and hydrogen. This second barrier insulating film can be formed by plasmanizing the second film forming gas containing silane, at least any one of N₂O and H₂O to react. Also the second barrier insulating film is the insulating film that contains silicon, oxygen, hydrogen, and carbon. This second barrier insulating film can be formed by plasmanizing the second film forming gas containing at least any one of siloxane and methylsilane (SiHₙ(CH₃)₄₋ₙ:n=0, 1, 2, 3), or at least any one of N₂O, H₂O and CO₂ to react.

In addition, an insulating film having the low dielectric constant may be further formed on the above barrier insulating film. In this case, the barrier insulating film and the insulating film having the low dielectric constant may be employed as the interlayer insulating film by forming a new wiring made of the copper film or consisting mainly of the copper film on the insulating film having the low dielectric constant.

### BRIEF DESCRIPTION OF THE DRAWINGS

FIG.1 is a side view showing a configuration of a plasma enhanced film forming apparatus employed in a semiconductor device manufacturing method as embodiments of the present invention;
FIG.2 is a graph showing relationships of a relative dielectric constant and a refractive index with respect to an NH₃ flow rate of a film forming gas for a first barrier insulating film according to a first embodiment of the present invention;
FIG.3 is a graph showing a leakage current density of the first barrier insulating film according to the first embodiment of the present invention;
FIG.4 is a graph showing a copper diffusion preventing capability of the first barrier insulating film according to the first embodiment of the present invention;
FIG.5 is a graph showing the leakage current density of another first barrier insulating film according to the first embodiment of the present invention;
FIG.6 is a graph showing the copper diffusion preventing capability of another first barrier insulating film according to the first embodiment of the present invention;
FIG.7 is a graph showing relationships of the relative dielectric constant and the refractive index with respect to the N₂O flow rate of the film forming gas for a second barrier insulating film according to the first embodiment of the present invention;
FIG.8 is a graph showing the leakage current density of the second barrier insulating film according to the first embodiment of the present invention;
FIG.9 is a graph showing the copper diffusion preventing capability of the second barrier insulating film according to the first embodiment of the present invention; and
FIGS.10A and 10B are sectional views showing a semiconductor device manufacturing method according to a second embodiment of the present invention.

### DESCRIPTION OF THE PREFERRED EMBODIMENTS

Embodiments of the present invention will be explained with reference to the accompanying drawings hereinafter.

### (First Embodiment)

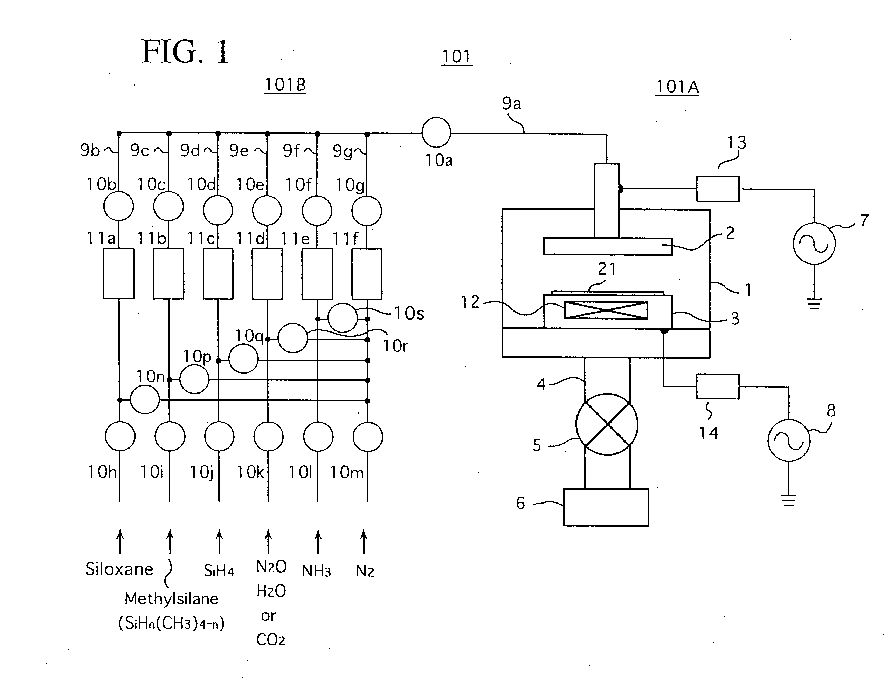

FIG.1 is a side view showing a configuration of a parallel plate type plasma enhanced film forming apparatus 101 employed in a semiconductor device manufacturing method according to embodiments of the present invention.

This plasma enhanced film forming apparatus 101 consists of a film forming portion 101A that is the place at which an insulating film is formed on a substrate 21 by the plasma gas, and a film forming gas supplying portion 101B having a plurality of gas supply sources constituting the film forming gas.

As shown in FIG.1, the film forming portion 101A is equipped with a chamber 1 being capable of reducing an inner pressure. The chamber 1 is connected to an exhausting unit 6 via an exhaust pipe 4. A switching valve 5 for controlling the communication/noncommunication between the chamber 1 and the exhausting unit 6 is provided in the middle of the exhaust pipe 4. A pressure measuring means such as a vacuum gauge (not shown), or the like for monitoring the pressure in the chamber 1 is provided to the chamber 1.

A pair of upper electrode 2 and lower electrode 3 are provided in the chamber 1 to oppose to each other. A high frequency power supply (RF power supply) 7 for supplying the high frequency power of the frequency 13.56 MHz is connected to the upper electrode 2. A low frequency power supply 8 for supplying the low frequency power of the frequency 380 kHz is connected to the lower electrode 3. The film forming gas is plasmanized by supplying the powers from these power supplies 7, 8 to the upper electrode 2 and the lower electrode 3. The upper electrode 2, the lower electrode 3, and the power supplies 7, 8 constitute a plasma generating means for plasmanizing the film forming gas.

The upper electrode 2 is also used as the distributor of the film forming gas. A plurality of through holes are formed in the upper electrode 2, and opening portions of the through holes on the surface opposing to the lower electrode 3 serve as discharge ports (introducing ports) of the film forming gas. The discharge ports of the film forming gas, etc. are connected to the film forming gas supplying portion 101B via a pipe 9a. Also, as the case may be, sometimes a heater (not shown) is provided to the upper electrode 2. This is because, if the upper electrode 2 is heated up to the temperature of about 100 °C during the film formation, the particles consisting of the reaction product of the film forming gas, etc. can be prevented from adhering to the upper electrode 2.

The lower electrode 3 is also used as a loading table of the substrate 21 and is equipped with a heater 12 for heating the substrate 21 on the loading table.

A siloxane supply source, a methylsilane (SiHn(CH₃)₄₋ₙ: n=0, 1, 2, 3) supply source, a silane (SiH₄) supply source, a supply source of N₂O, H₂O or CO₂ as the oxygen containing gas, an ammonia (NH₃) supply source, and a nitrogen (N₂) supply source are provided to the film forming gas supplying portion 101B.

These gases are supplied appropriately to the inside of the chamber 1 of the film forming portion 101A via branch pipes 9b to 9g and the pipe 9a to which all branch pipes 9b to 9g are connected. Flow rate adjusting means 11a to 11f and switching means 10b to 10m for controlling the communication/noncommunication of the branch pipes 9b to 9g are provided in the middle of the branch pipes 9b to 9g. A switching means 10a for controlling OPEN/CLOSE of the pipe 9a is provided in the middle of the pipe 9a.

In order to purge the residual gas in the branch pipes 9b to 9g by flowing the N₂ gas, switching means 10n, 10p to 10s for controlling the communication/noncommunication between the branch pipe 9g, which is connected to the N₂ gas supply source, and remaining branch pipes 9b to 9f are provided. In this case, the N₂ gas can purge the residual gas in the pipe 9a and the chamber 1 in addition to the branch pipes 9b to 9f. Further, the N₂ gas is also employed as the diluent gas.

According to the above film forming apparatus 101, the siloxane, methylsilane, and silane supply sources, the oxygen containing gas supply source, and the ammonia or nitrogen supply source are provided, and also the plasma generating means 2, 3, 7, 8 for plasmanizing the film forming gas are provided.

As a result, as shown in the following embodiment, the first barrier insulating film having the low dielectric constant and the second barrier insulating film having the high copper diffusion preventing capability and the small leakage current can be formed by the plasma enhanced CVD method. The first barrier insulating film contains silicon (Si), oxygen (O) and hydrogen (H), or Si, O, H and carbon (C). The second barrier insulating film contains Si, O, H, and nitrogen (N) or Si, O, H, N and C.

Then, as the plasma generating means, there is the means for generating the plasma by upper electrode 2 and lower electrode 3 of the parallel plate type, for example. The high frequency power supply 7 is connected to the upper electrode 2, and the low frequency power supply 8 is connected to the lower electrode 3. Therefore, the plasma can be generated by applying the powers of the high and low frequencies to the electrodes 2, 3 respectively. In particular, the insulating film formed in this manner becomes dense and has the low dielectric constant.

The combinations of the power applications to the lower electrode 3 and the upper electrode 2 are given as follows.

First, the high frequency power of more than 1 MHz is applied to the upper electrode 2, while the low frequency power of more than 100 kHz but less than 1 MHz is applied to the lower electrode 3. Second, the low frequency power is not applied to the lower electrode 3, while the high frequency power of more than 1 MHz is applied to the upper electrode 2. Third, the high frequency power is not applied to the upper electrode 2, while the low frequency power is applied to the lower electrode 3.

Next, as for siloxane, methylsilane, oxygen containing gas as the film forming gas which is applied for the present invention, followings may be employed as typical examples.
(i) siloxane
   hexamethyldisiloxane (HMDSO:(CH₃)₃Si-O-Si(CH₃)₃)
   octamethylcyclotetrasiloxane (OMCTS:((CH₃)₂)₄Si₄O₄ 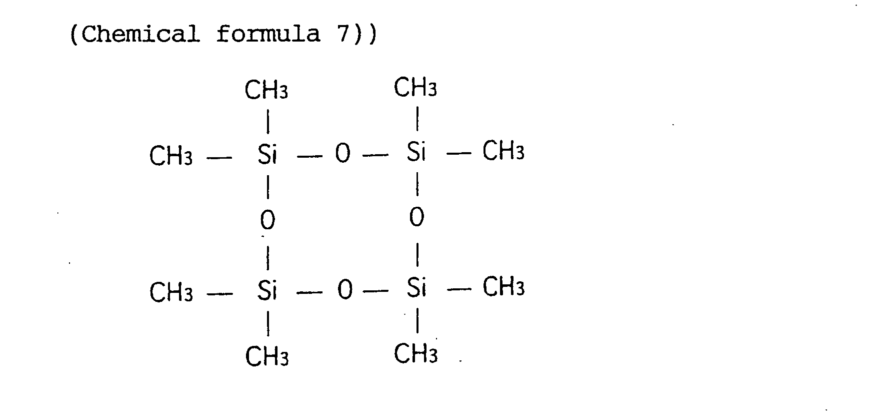 tetramethylcyclotetrasiloxane (TMCTS:(CH₃H)₄Si₄O₄ 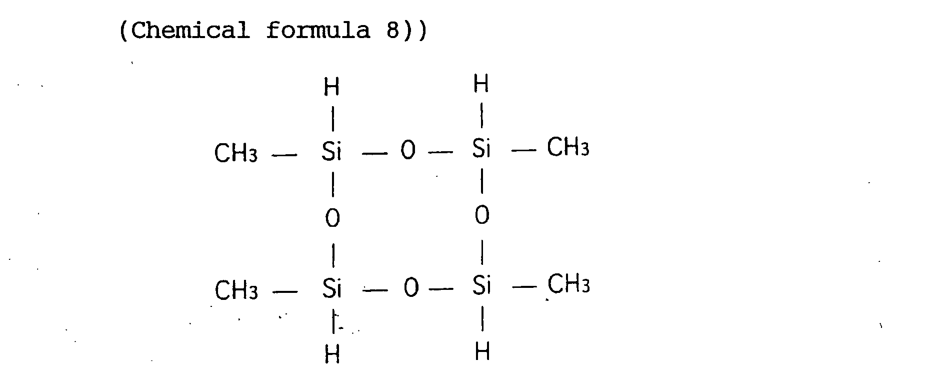
(ii) methylsilane (SiHₙ(CH₃)₄₋ₙ: n=0, 1, 2, 3)
   monomethylsilane (SiH₃(CH₃))
   dimethylsilane (SiH₂(CH₃)₂)
   trimethylsilane (SiH(CH₃)₃)
   tetramethylsilane (Si(CH₃)₄)
(iii) oxygen containing gas
   nitrogen monoxide (N₂O)
   water (H₂O)
   carbon dioxide (CO₂)

Then, the experiment made by the inventors of this application will be explained hereunder.

Experimental samples are prepared by executing the plasma enhanced surface treatment prior to the film formation, the film formation, and the annealing after the film formation. The plasma enhanced surface treatment conditions, the film forming conditions, and the annealing conditions are given as follows.

According to film forming conditions 1, 1a described in the following, the first barrier insulating film containing Si, O, H and C is formed on the Si substrate and the copper film by the plasma-enhanced CVD method (PECVD method). Also, according to film forming conditions 2 described in the following, the second barrier insulating film containing Si, O, H, N and C is formed on the Si substrate and the copper film by the plasma-enhanced CVD method (PECVD method).

In this case, the time (stabilization period) required for the substitution of the gas in the chamber from the introduction of the gas to the start of the film formation (plasma excitation) is set to one minute and 30 seconds in the film formation. Also, in order to prevent the adhesion of the reaction product onto the upper electrode 2, this upper electrode 2 is heated up to 100 °C during this period.

First, test results of the first barrier insulating film (the tested insulating film) will be explained hereunder according to test samples.
(i)Plasma enhanced surface treatment conditions:
   (a)Process gas
      NH₃ flow rate: 400 sccm
      Gas pressure (parameter): 4 Torr
   (b)Plasma exciting conditions
      Lower electrode: low frequency power (frequency 380 kHz)=0 W
      Upper electrode: high frequency power (frequency 13.56 MHz)=400 W (0.963 W/cm²)
   (c)Substrate heating condition: 375 °C
(ii)Film forming conditions 1:
   (a)First film forming gas
      HMDSO flow rate: 50 sccm
      N₂O flow rate: 200 sccm
      NH₃ flow rate (parameter): 0, 50, 100, 200, 400, 600, 750 sccm
      Gas pressure (parameter): 1 Torr
   (b)Plasma exciting conditions
      Lower electrode: low frequency power (frequency 380 kHz)=150 W (0.36 W/cm²)
      Upper electrode: high frequency power (frequency 13.56 MHz)=0 W
   (c)Substrate heating condition: 375 °C
(iii)Annealing conditions:
   (a)Substrate heating condition: 450 °C
   (b)Time: 4 hours

### (a) the relative dielectric constant and the refractive index of the tested insulating film

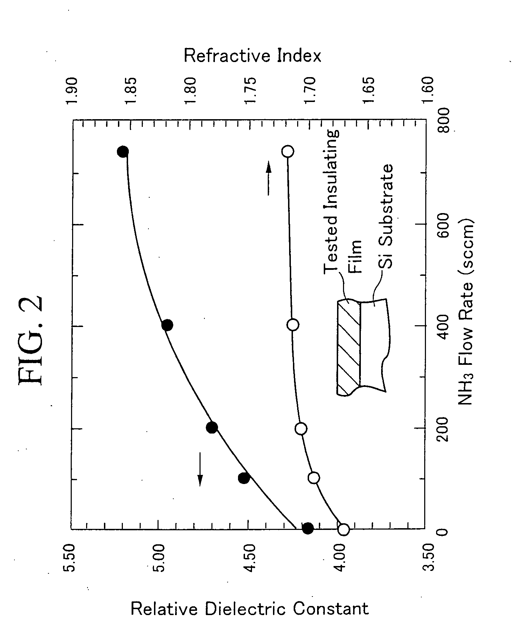

FIG.2 is a graph showing relationships of the relative dielectric constant and the refractive index of the film formed on the Si substrate with respect to the NH₃ flow rate of the first film forming gas. Where an ordinate on the left side denotes the relative dielectric constant of the tested insulating film in a linear scale, an ordinate on the right side denotes the refractive index of the tested insulating film in a linear scale, and an abscissa denotes the NH₃ flow rate (sccm) of the first film forming gas in a linear scale.

The tested insulating film was formed on the Si substrate under seven conditions that the NH₃ flow rate of the first film forming gas was set to 0, 50, 100, 200, 400, 600, 750 sccm respectively, without the application of the high frequency power onto the upper electrode 2 out of parameters of the above film forming conditions 1. The relative dielectric constant was measured as follows. That is, the mercury probe was brought into contact with a surface of the tested insulating film, then the DC bias voltage was applied between the mercury probe and the Si substrate, and then the signal voltage of the frequency 1 MHz was superposed, so that the C-V measurement was carried out. The measured relative dielectric constant is indicated by a ● mark in FIG.2. Also, the refractive index was measured by the ellipsometer using the He-Ne laser having the wavelength of 6338 Angstrom. The measured refractive index is indicated by a ○ mark in FIG.2.

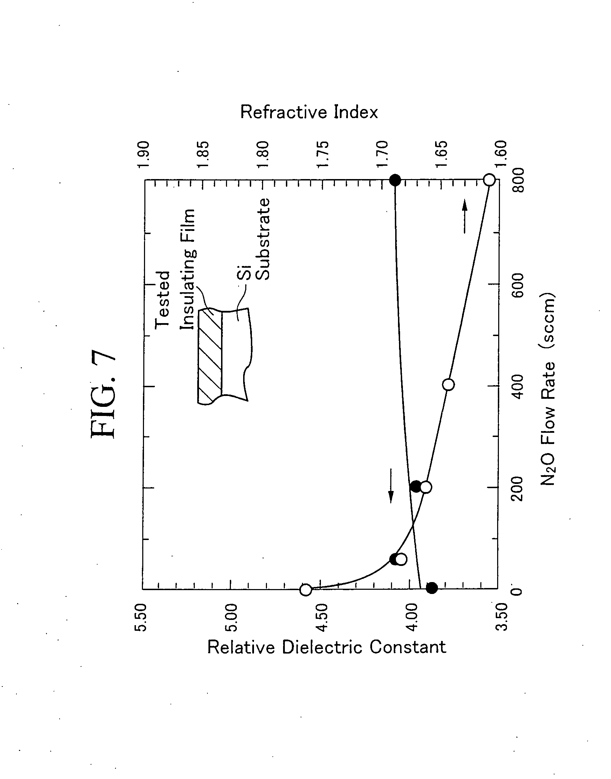

According to FIG.2, the relative dielectric constant was increased with the increase of the NH₃ flow rate. The relative dielectric constant that was about 4.2 when the NH₃ flow rate was 0 sccm became about 5.2 when the NH₃ flow rate was 750 sccm. The relative dielectric constant was higher than the tested insulating film, described later, that is shown in FIG.7 and does not contain the nitrogen.

The refractive index was gradually increased with the increase of the NH₃ flow rate. The refractive index that was about 1.67 when the NH₃ flow rate was 0 sccm became about 1.72 when the NH₃ flow rate was 750 sccm. The refractive index became higher in contrast to the tested insulating film that is shown in FIG.7 and does not contain the nitrogen (equivalent to the case that the NH₃ flow rate is 0 sccm). In this case, the fact that the refractive index is higher directly indicates that the film is denser.

### (b) the leakage current of the tested insulating film

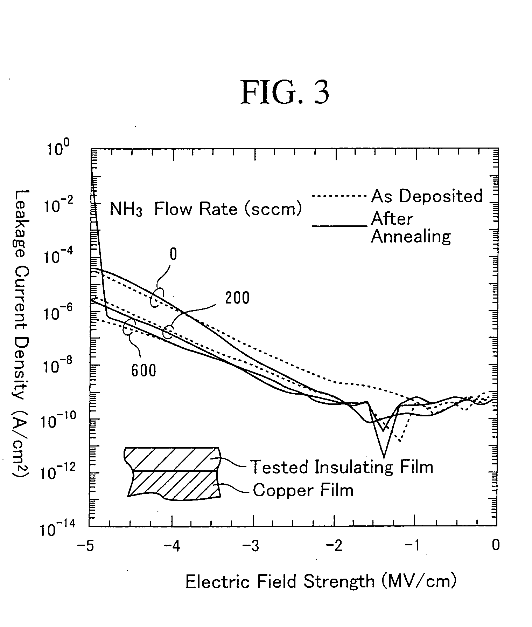

FIG.3 is a graph showing relationships between the electric field strength applied to the tested insulating film and the leakage current density of the tested insulating film before and after the annealing. Where an ordinate denotes the leakage current density (A/cm²) of the tested insulating film in a linear scale, and an abscissa denotes the electric field strength (MV/cm) in a linear scale. The NH₃ flow rates of 0, 200, 600 sccm of the first film forming gas were used as the parameter.

The tested insulating film was formed on the copper film. The copper film was grounded immediately after the film formation but before the annealing and after the annealing, and then the mercury probe was brought into contact with the surface of the tested insulating film. Then, the leakage current was measured by applying the negative voltage to the mercury probe, and then the leakage current density was calculated based on the area of the mercury probe. The electric field strength in the abscissa is the electric field strength obtained based on the negative voltage at that time. A minus sign of the electric field strength signifies that the electric field is directed from the copper film to the mercury probe.

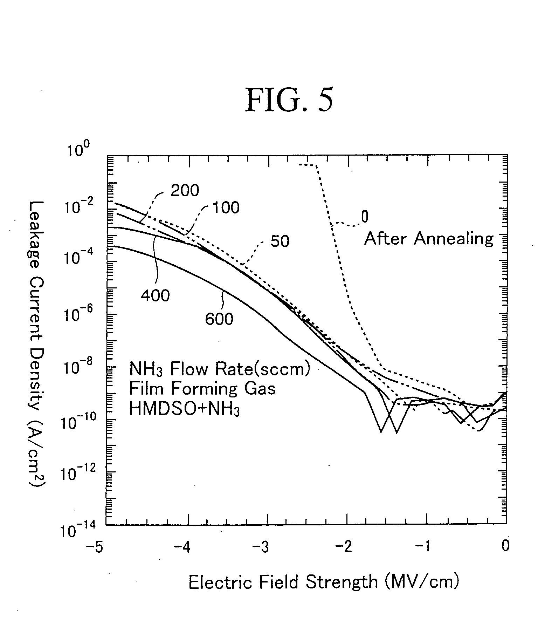

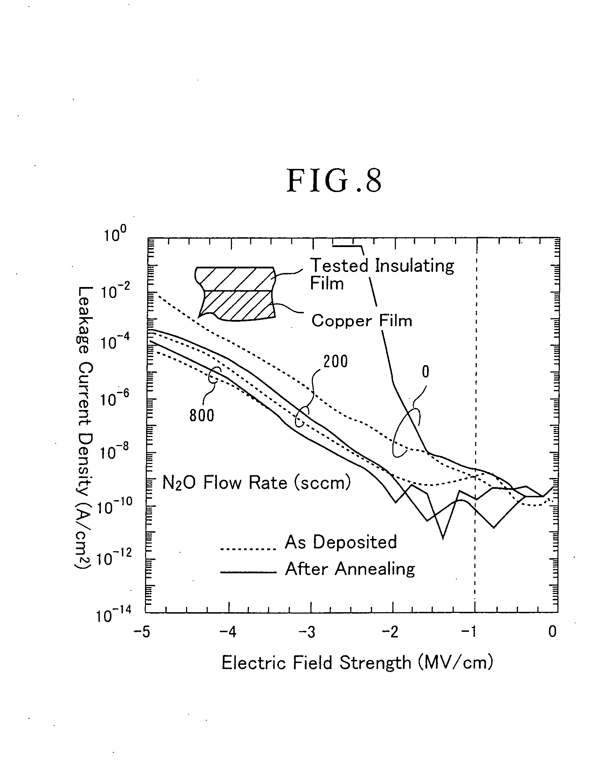

According to FIG.3, the leakage current density has the small dependency on the NH₃ flow rate, except the sample that was measured at the NH₃ flow rate of 600 sccm of the first film forming gas. The leakage current density was increased other than the sample, which was measured at the NH₃ flow rate of 600 sccm, as the electric field strength was increased in the negative direction, and was 10⁻⁶ to 10⁻⁵ A/cm² at -5 MV/cm. This leakage current density was smaller in one figure than that of the tested insulating film that is shown in FIG.5 and contains the nitrogen or that of the tested insulating film that is shown in FIG.8 and does not contain the nitrogen, as described later.

In this case, when the NH₃ flow rate was 600 sccm, the abrupt increase of the leakage current density appeared at the electric field strength of -5 MV/cm. This exhibits the dielectric breakdown of the insulating film. However, although the dielectric breakdown characteristics of other samples in FIG.3 are considered together, it is difficult to consider this dielectric breakdown as the dielectric breakdown due to the copper diffusion. This dielectric breakdown may be considered as the peculiar dielectric breakdown due to the defect, etc. of the insulating film.

### (c) the copper diffusion preventing capability of the tested insulating film

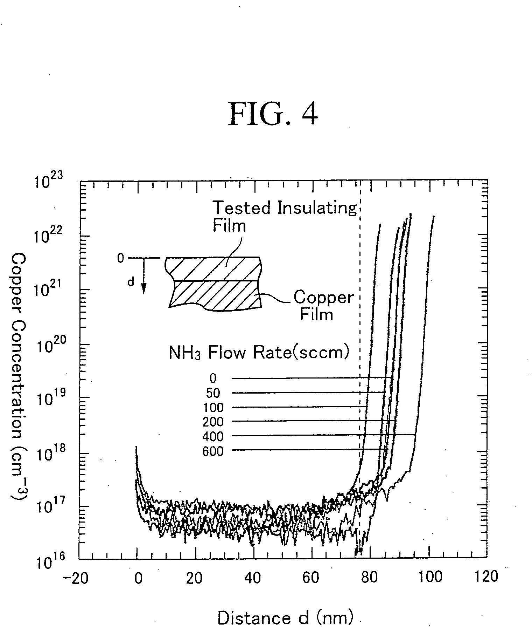

FIG.4 is a graph showing tested results of the copper diffusion preventing capability of the tested insulating film. The NH₃ flow rates of 0, 50, 100, 200, 400, 600 of the first film forming gas were used as the parameter. Where an ordinate denotes a copper density (cm⁻³) in a linear scale, and an abscissa denotes a distance d (nm) measured from the surface of the tested insulating film in the direction of the copper film in a linear scale.

The tested insulating film was formed on the copper film. A dotted line shows the boundary surface in FIG.4. The copper diffusion preventing capability of the tested insulating film was evaluated by measuring the copper density in the tested insulating film after the annealing explained above.

According to FIG.4, there was no sample that the copper was diffused into the tested insulating film. It was found that, as was expected, the tested insulating film has the sufficiently high diffusion preventing capability with respect to the copper.

Next, test results of another first barrier insulating film (tested insulating film) will be explained based on the experimental samples. The plasma enhanced surface treatment conditions and the annealing conditions were set identically to the above conditions, and the film forming conditions were set as follows. In contrast to the film forming conditions 1, no N₂O was added to the film forming gas.

### Film forming conditions 1a:

(a)First film forming gas
   HMDSO flow rate: 50 sccm
   NH₃ flow rate (parameter): 0, 50, 100, 200, 400, 600 sccm
   Gas pressure (parameter): 1 Torr
(b)Plasma exciting conditions
   Lower electrode: low frequency power (frequency 380 kHz)=150 W (0.36 W/cm²)
   Upper electrode: high frequency power (frequency 13.56 MHz)=0 W
(c)Substrate heating condition: 375 °C

### (a) the leakage current of the tested insulating film

FIG.5 is a graph showing a relationship between the electric field strength applied to the tested insulating film and the leakage current density of the tested insulating film after the annealing. Where an ordinate denotes the leakage current density (A/cm²) of the tested insulating film in a linear scale, and an abscissa denotes the electric field strength (MV/cm) in a linear scale. The NH₃ flow rate of the first film forming gas is used as the parameter.

The tested insulating film was formed on the copper film. After the annealing was carried out under the above annealing conditions, the copper film was grounded and then the mercury probe was brought into contact with the surface of the tested insulating film. Then, the leakage current was measured by applying the negative voltage to the mercury probe, and then the leakage current density was calculated by the area of the mercury probe. The electric field strength in the abscissa is the electric field strength obtained based on the negative voltage at that time. The minus sign of the electric field strength indicates that the electric field is directed from the copper film to the mercury probe.

According to FIG.5, the sample formed when the NH₃ flow rate of the first film forming gas was 0 sccm caused the dielectric breakdown. It may be considered that this breakdown was caused due to the diffusion of the copper. Remaining insulating films formed by using the film forming gas containing NH₃ did not result in the dielectric breakdown.

In this case, the value of the leakage current had the small dependency on the NH₃ flow rate. The leakage current density was increased as the electric filed strength was increased in the negative direction, and was 10-4 to 10-2 A/cm⁻² when the electric field strength was - 5 MV/cm. This leakage current density was the almost same level as that of the second barrier insulating film that is described later and does not contain the nitrogen.

### (b) the copper diffusion preventing capability of the tested insulating film

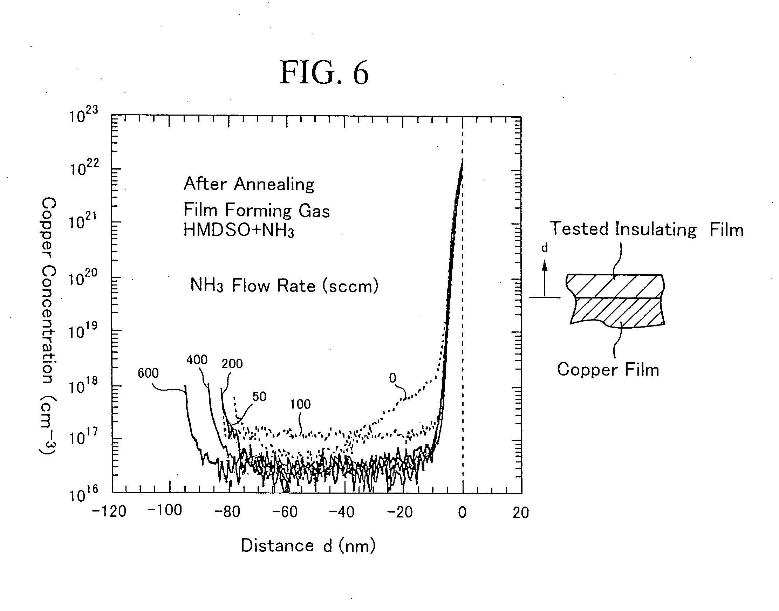

FIG.6 is a graph showing test results of the copper diffusion preventing capability of the tested insulating film after the annealing. The NH3 flow rate of the first film forming gas was used as the parameter. Where an ordinate denotes the copper concentration (cm⁻³) in a logarithmic scale, and an abscissa denotes the distance d (nm) measured from the surface of the tested insulating film in the direction of the copper film in a linear scale.

The tested insulating film was formed on the copper film. In FIG.6, a dotted line depicted in the vertical direction indicates the boundary between them. The copper diffusion preventing capability of the tested insulating film was evaluated by measuring the copper concentration in the tested insulating film after the annealing explained above.

According to FIG.6, it was found that, when the NH₃ flow rate was 0 sccm, i.e., NH₃ was not added, the copper was diffused into the tested insulating film.

Next, test results of the second barrier insulating film (tested insulating film) will be explained based on the experimental samples. The plasma surface treatment conditions and the annealing conditions were set identically to the above conditions, and the film forming conditions were set as follows.

### Film forming conditions 2:

(a)Second film forming gas
   HMDSO flow rate: 50 sccm
   N₂O flow rate (parameter): 0, 50, 200, 400, 800 sccm
   Gas pressure (parameter): 1 Torr
(b)Plasma exciting conditions
   Lower electrode: low frequency power (frequency 380 kHz)=150 W (0.36 W/cm²)
   Upper electrode: high frequency power (frequency 13.56 MHz)=0 W
(c)Substrate heating condition: 375 °C

### (a) the relative dielectric constant and the refractive index of the tested insulating film

FIG.7 is a graph showing relationships of the relative dielectric constant and the refractive index of the film formed on the Si substrate with respect to the N₂O flow rate of the second film forming gas. Where an ordinate on the left side denotes the relative dielectric constant of the tested insulating film in a linear scale, an ordinate on the right side denotes the refractive index of the tested insulating film in a linear scale, and an abscissa denotes the N₂O flow rate of the second film forming gas in a linear scale.

The tested insulating film was formed on the Si substrate under five conditions that the N₂O flow rate was set to 0, 50, 200, 400, 800 sccm respectively, without the application of the high frequency power onto the upper electrode 2 out of parameters of the above film forming conditions 2. The relative dielectric constant was measured in the following manner. That is, the mercury probe was brought into contact with a surface of the tested insulating film, then the DC bias voltage was applied between the mercury probe and the Si substrate, and then the signal of the frequency 1 MHz was superposed, so that the C-V measurement was carried out. The measured relative dielectric constant is indicated by the ● mark in FIG.7. Also, the refractive index was measured by the ellipsometer using the He-Ne laser having the wavelength of 6338 Angstrom. The measured refractive index is indicated by a ○ mark in FIG.7.

According to FIG.7, the relative dielectric constant was gradually increased with the increase of the N₂O flow rate. The relative dielectric constant that was about 3.9 when the N₂O flow rate was 0 sccm became about 4.1 when the N₂O flow rate was 800 sccm.

The refractive index was abruptly decreased with increase of the N₂O flow rate of 0 sccm to 50 sccm, and then was gradually decreased with the increase of the N₂O flow rate. The refractive index that was about 1.76 when the N₂O flow rate was 0 sccm became about 1.68 when the N₂O flow rate was 50 sccm and also became about 1.62 when the N₂O flow rate was 800 sccm. As explained in the test results of the first barrier insulating film, this fact shows that the first barrier insulating film containing the nitrogen is denser.

### (b) the leakage current of the tested insulating film

FIG.8 is a graph showing relationships between the electric field strength applied to the tested insulating film and the leakage current density of the tested insulating film before and after the annealing. Where an ordinate denotes the leakage current density (A/cm²) of the tested insulating film in a logarithmic scale, and an abscissa denotes the electric field strength (MV/cm) in a linear scale. The N₂O flow rates of 0, 200, 800 sccm of the second film forming gas were used as the parameter.

The tested insulating film was formed on the copper film. The copper film was grounded immediately after the film formation but before the annealing and after the annealing, and then the mercury probe was brought into contact with the surface of the tested insulating film. Then, the leakage current was measured by applying the negative voltage to the mercury probe, and then the leakage current density was calculated based on the area of the mercury probe. The electric field strength in the abscissa is the electric field strength obtained based on the negative voltage at that time. The minus sign of the electric field strength signifies that the electric field was directed from the copper film to the mercury probe.

According to FIG.8, in the sample formed when the N₂O flow rates of the second film forming gas was 0 sccm, the leakage current was abruptly increased at the low electric field. It may be considered that the dielectric breakdown due to the diffusion of the copper was generated after the annealing. Remaining insulating films formed by the film forming gas containing N₂O did not come to the breakdown.

In this case, the leakage current density has the small dependency on the N₂O flow rate, except the sample that was measured at the N₂O flow rate 0 sccm of the second film forming gas. The leakage current density was increased as the electric field strength was increased in the negative direction, and was 10⁻⁵ to 10⁻⁴ A/cm² at -5 MV/cm. This leakage current density was larger in one figure than that of the first barrier insulating film that was explained in FIG.3 and contains the nitrogen.

### (c) the copper diffusion preventing capability of the tested insulating film

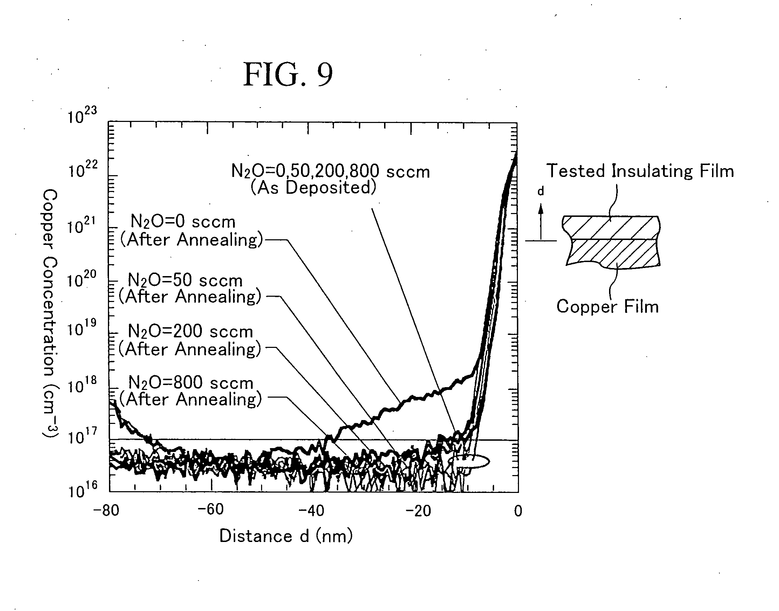

FIG.9 is a graph showing test results of the copper diffusion preventing capability of the tested insulating film before and after the annealing. The N₂O flow rate of the second film forming gas was used as the parameter. Where an ordinate denotes the copper concentration (cm⁻³) in a logarithmic scale, and an abscissa denotes the distance d (nm) measured from the surface of the tested insulating film in the direction of the copper film in a linear scale.

The tested insulating film was formed on the copper film. A dotted line shows the boundary surface in FIG.9. The copper diffusion preventing capability of the tested insulating film was evaluated by measuring the copper concentration in the tested insulating film, immediately after the film formation prior to the annealing, and after the annealing explained above.

According to FIG.9, it was found that, when the N₂O flow rate was 0 sccm, i.e., N₂O was not added, the copper was diffused into the tested insulating film. In this case, the diffusion of the copper was not watched in the sample to which N₂O was added.

As described above, according to the first embodiment of the present invention, it was found that the insulating film containing Si, O, H, N and C is dense and its relative dielectric constant is relatively high because such film contains the nitrogen, and its leakage current was small.

Also, the insulating film containing Si, O, H and C has the low dielectric constant, its density is relatively small, and its leakage current is relatively large.

Both the insulating film formed by using the first film forming gas 1a or 1 and the insulating film formed by using the second film forming gas 2 containing N₂O are excellent in the copper diffusion preventing capability. Thus, the clear difference does not appears between them.

According to the total evaluation, the insulating film containing Si, O, H, N and C is excellent in denseness, and therefore such film has the aptitude as the first barrier insulating film. The insulating film containing Si, O, H and C has the aptitude as the second barrier insulating film.

As described above, a double-layered structure or more, which is constructed by at least the first and second barrier insulating films, is employed as the barrier insulating film. Then, in order not to damage the functions such that the leakage current is small and the copper diffusion preventing capability is sufficiently high, the film thickness of the first barrier insulating film that has the relatively high relative dielectric constant is set to the thin film thickness, while the film thickness of the second barrier insulating film that has the low relative dielectric constant is set to the thick film thickness that is necessary and sufficient for the overall film thickness of the barrier insulating film. As a result, the overall barrier insulating film has the low relative dielectric constant, the small leakage current, and the sufficiently high copper diffusion preventing capability.

The present invention is explained in detail with reference to the first embodiment as above, but the scope of the present invention is not limited to the example shown particularly in the above embodiment. Variations of the above embodiment in the scope not to depart from the gist of the present invention are contained in the spirit of the present invention.

For example, in the above first embodiment, as the first film forming gas to form the insulating film containing Si, O, H, N and C, HMDSO+N₂O+NH₃ or HMDSO+NH₃ is employed. As the silicon containing gas, other siloxane recited in above (i) item, e.g., OMCTS or TMCTS may be employed in place of HMDSO. Also, any one of methylsilane recited in above (ii) item may be employed in place of siloxane. In addition, as the oxygen containing gas, H₂O or CO₂ recited in above (iii) item may be employed in place of N₂O. As the nitrogen containing gas, N₂ may be employed in place of NH₃. That is, as the first film forming gas, various combinations of the silicon containing gas being selected from those gases, the oxygen containing gas, and the nitrogen containing gas or various combinations of the silicon containing gas and the nitrogen containing gas may be employed.

Further, as the second film forming gas to form the insulating film containing Si, O, H and C, HMDSO+N₂O is employed. As silicon containing gas, other siloxane recited in above (i) item, e.g., OMCTS or TMCTS may be employed in place of HMDSO. Also, any one of methylsilane recited in above (ii) item may be employed in place of siloxane. In addition, as the oxygen containing gas, H₂O or CO₂ recited in above (iii) item may be employed in place of N₂O. Therefore, as the second film forming gas, combinations of the silicon containing gas being selected from those gases and the oxygen containing gas may be employed.

Besides, the insulating film containing Si, O, H, N and C was examined as the first barrier insulating film, and it was checked that such film has its aptitude. Also, the insulating film containing Si, O, H and N has its aptitude. In this case, silane (SiH₄) may be employed instead of HMDSO, any one of N₂O and H₂O may be employed as the oxygen containing gas, and any one of N₂ and NH₃ may be employed as the nitrogen containing gas.

Moreover, the insulating film containing Si, O, H and C was examined as the second barrier insulating film, and it was checked that such film has its aptitude. Also, the insulating film containing Si, O and H has its aptitude. In this case, silane (SiH₄) may be employed instead of HMDSO, and any one of N₂O and H₂O may be employed as the oxygen containing gas.

### (Second Embodiment)

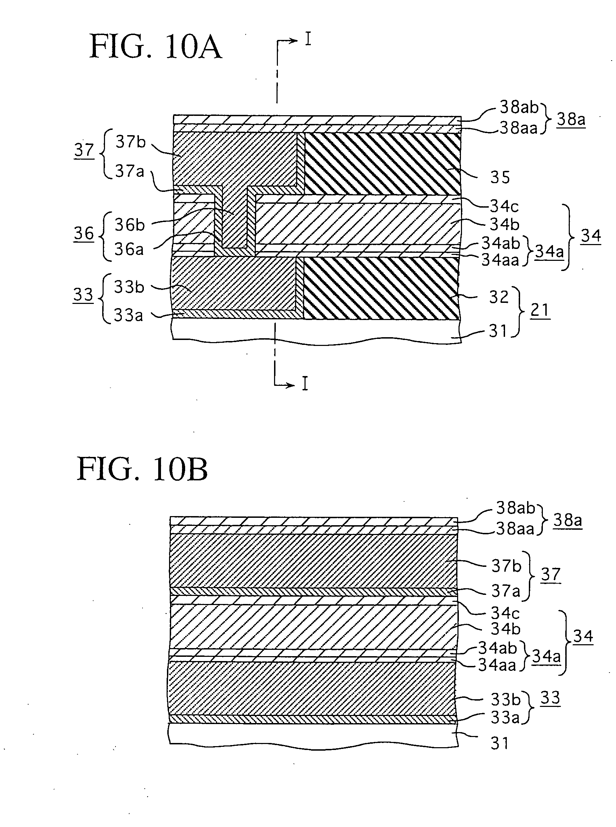

FIG.10A is a sectional view showing a semiconductor device manufacturing method as a second embodiment of the present invention. FIG.10B is a sectional view taken along a I-I line in FIG.10A.

In FIGS.10A and 10B, this manufacturing method of the present invention is applied to a barrier insulating film 34a, which covers the lower wiring consisting mainly of the copper film, out of an interlayer insulating film 34 containing barrier insulating films 34a, 34c, and to a barrier insulating film 38a, which covers the upper wiring consisting mainly of the copper film.

First, a wiring-burying insulating film 32 made of an SiO₂ film or an SiOCH film having a film thickness of about 1 µm is formed on a semiconductor substrate 31. In this case, the SiOCH film is the insulating film that contains Si, O, C, H in the film.

Then, a wiring recess is formed by etching the wiring- burying insulating film 32, and then a TaN film 33a is formed as the copper diffusion preventing film on an inner surface of the wiring recess. Then, a copper seed layer (not shown) is formed on a surface of the TaN film 33a by the sputter method, and then the copper film is buried by the plating method. Then, a resultant surface is planarized by polishing the copper film and the TaN film 33a, both being projected from the wiring recess, by virtue of the CMP (Chemical Mechanical Polishing) method. Accordingly, the lower wiring consisting of the copper film 33b and the TaN film 33a is formed. Elements of the above construct a substrate 21.

Then, a barrier insulating film 34a that comes into contact with the copper film 33b out of an interlayer insulating film 34 is formed by the plasma enhanced CVD method. Their details will be explained as follows.

First, the surface of the substrate 21 is subjected to the plasma process before the barrier insulating film 34a is formed. The process gas conditions are set equal to the conditions shown in the first embodiment.

More particularly, the substrate 21 is introduced into the chamber 1 of the film forming apparatus 101 and then held on the substrate holder 3. Then, the substrate 21 is heated and maintained at the temperature of 375 °C. Then, the process gas is introduced into the chamber 1 and the gas pressure is maintained at 1 Torr. Then, the high frequency power of 400 W (0.963 W/cm²) is applied to the upper electrode. The low frequency power is not applied to the lower electrode. Therefore, the process gas is plasmanized. The natural oxide film on the surface of the copper film 33b is removed by keeping this state for a predetermined time.

Then, in order to form the barrier insulating film 34a, the substrate temperature is held at 375 °C. The HMDSO gas, the N₂O gas, and the NH₃ gas are introduced into the chamber 1 of the plasma enhanced film forming apparatus 101 shown in FIG.1 at the flow rates of about 50 sccm, about 200 sccm, and about 50 sccm respectively to maintain the pressure at 1 Torr.

Then, the low frequency power of about 150 W (0.36 W/cm²) having the frequency 380 kHz is applied to the lower electrode 3. The high frequency power is not applied to the upper electrode 2.

As a result, HMDSO, N₂O, and NH₃ are plasmanized and then this state is maintained for 10 seconds. It results in forming the first barrier insulating film 34aa made of a PE-CVD SiO₂ film, which contains Si, O, H, N and C and has a film thickness of 20 nm.

Then, while maintaining the substrate temperature at 375 °C, the HMDSO gas and the N₂O gas are introduced at the flow rates of about 50 sccm and about 200 sccm respectively to maintain the pressure at 1 Torr.

Then, the low frequency power of about 150 W (0.36 W/cm²) having the frequency 380 kHz is applied to the lower electrode 3. The high frequency power is not applied to the upper electrode 2.

As a result, HMDSO and N₂O are plasmanized and then this state is maintained for 10 seconds. It causes to form the second barrier insulating film 34ab made of the PE-CVD SiO₂ film, which contains Si, O, H, N and C and has a film thickness of 20 nm.

Finally, the above procedures result in forming a barrier insulating film 34a consisting of the first barrier insulating film 34aa and the second barrier insulating film 34ab.

Then, an interlayer insulating film 34 is formed by forming sequentially the insulating film 34b and the barrier insulating film 34c on the barrier insulating film 34a by the normal well-known forming method of the insulating film having the low dielectric constant.

Then, a wiring-burying insulating film 35 made of the SiO² film or the SiOCH film of about 1 µm thickness is formed by the same method that is used to form the SiO² film or the SiOCH film on the interlayer insulating film 34.

Then, a connecting conductor 36 consisting mainly of the copper film and an upper wiring 37 consisting mainly of the copper film are formed by the well-known dual damascene method. In FIGS.10A and 10B, symbols 36a, 37a are the TaN film and symbols 36b, 37b are the copper film.

Then, a barrier insulating film 38a consisting of a first barrier insulating film 38aa and a second barrier insulating film 38ab is formed on the overall surface under the same film forming conditions as the barrier insulating films 34aa and 34ab. As a result, the semiconductor device is completed.

As described above, according to the second embodiment, NH₃ of the film forming gas is introduced in the former half and is stopped in the latter half. It results in easily forming double-layered barrier insulating films 34a, 38a that, as a whole, has the small leakage current, the sufficiently high copper diffusion preventing capability, and the low relative dielectric constant.

As a consequence, if the barrier insulating films 34a, 38a are interposed between the copper wirings 33, 37 as a part of the interlayer insulating film, it results in obtaining the semiconductor device that can attain the high speed signal transmission and have the high reliability.

The present invention is explained in detail with reference to the second embodiment, but the scope of the present invention is not limited to the example shown particularly in the above embodiment. Variations of the above embodiment in the scope not to depart from the gist of the present invention are contained in the spirit of the present invention.

For example, in the second embodiment, the barrier insulating films 34a, 38a have the double-layered structure that consists of the first barrier insulating films 34aa, 38aa containing the nitrogen and the second barrier insulating films 34ab, 38ab not containing the nitrogen. However, there may be employed a triple-layered structure or more, which is subject to containing at least the first barrier insulating films 34aa, 38aa containing the nitrogen and the second barrier insulating films 34ab, 38ab not containing the nitrogen.

Also, the first barrier insulating films 34aa, 38aa containing the nitrogen are formed to come into contact with the copper wiring, while the second barrier insulating films 34ab, 38ab not containing the nitrogen are formed on the first barrier insulating film 34aa, 38aa. In this case, the opposite arrangement may be employed.

Moreover, though the barrier insulating film 34c is formed on the insulating film 34b, the barrier insulating film 34c may be omitted to form the wiring 37 made of the copper film 37b or consisting mainly of the copper film 37b directly on the insulating film 34b having a low relative dielectric constant.

As described, the present invention is provided with the double-layered structure or more having at least the first barrier insulating film containing the nitrogen, that can put enough confidence in the copper diffusion preventing capability, etc. since such film has the high denseness but is relatively higher in relative dielectric constant, and the second barrier insulating film not containing the nitrogen, that does not put enough confidence in the copper diffusion preventing capability, etc. since such film is slightly inferior in denseness but is lower in relative dielectric constant, is employed as the barrier insulating film to cover the copper film.

According to this double-layered structure, since respective barrier insulating films can make up for mutually, the barrier insulating film, as a whole, has the small leakage current, the sufficiently high copper diffusion preventing capability, and the low relative dielectric constant.

In particular, if this barrier insulating film is interposed between the copper wirings as a part of the interlayer insulating film, there can be obtained the semiconductor device that can attain the high speed signal transmission and have the high reliability.

## Claims

1. A semiconductor device having a barrier insulating film that covers a wiring (33, 37) made of a copper film (33b, 37b) or consisting mainly of the copper film (33b, 37b) on a substrate (31),
the barrier insulating film (34a, 38a) comprising:
a double-layered structure or more provided with at least a first barrier insulating film (34aa, 38aa) containing silicon, oxygen, nitrogen and hydrogen or silicon, oxygen, nitrogen, hydrogen and carbon, and a second barrier insulating film (34ab, 38ab) containing silicon, oxygen and hydrogen or silicon, oxygen, hydrogen and carbon.

2. A semiconductor device according to claim 1, further comprising:
an insulating film (34b) having a low dielectric constant on the barrier insulating film (34a).

3. A semiconductor device according to claim 2, wherein the barrier insulating film (34a) and the insulating film (34b) having the low dielectric constant constitute an interlayer insulating film (34), and the wiring (37) made of the copper film (37b) or consisting mainly of the copper film (37b) is formed on the insulating film (34b) having the low dielectric constant.

4. A semiconductor device manufacturing method comprising the steps of:
forming a first barrier insulating film (34aa, 38aa) containing either silicon, oxygen and hydrogen or silicon, oxygen, hydrogen and carbon by plasmanizing a first film forming gas to react; and
forming a second barrier insulating film (34ab, 38ab) containing either silicon, oxygen, nitrogen and hydrogen or silicon, oxygen, nitrogen, hydrogen and carbon by plasmanizing a second film forming gas to react,
whereby forming a barrier insulating film (34a, 38a) having a double-layered structure or more, which is provided with at least the first barrier insulating film (34aa, 38aa) and the second barrier insulating film (34ab, 38ab), to cover a wiring (33, 37) made of a copper film (33b, 37b) or consisting mainly of the copper film (33b, 37b) on a substrate (31).

5. A semiconductor device manufacturing method according to claim 4, wherein the first barrier insulating film (34aa, 38aa) is an insulating film containing silicon, oxygen, nitrogen, and hydrogen, and the first film forming gas contains silane (SiH₄), at least any one of N₂O and H₂O, and at least any one of N₂ and NH₃.

6. A semiconductor device manufacturing method according to claim 4, wherein the first barrier insulating film (34aa, 38aa) is an insulating film containing silicon, oxygen, nitrogen, hydrogen and carbon, and the first film forming gas contains at least any one of siloxane and methylsilane (SiHₙ(CH₃)₄₋ₙ:n=0, 1, 2, 3), at least any one of N₂O, H₂O and CO₂, and at least any one of N₂ and NH₃.

7. A semiconductor device manufacturing method according to claim 6, wherein siloxane is formed of any one of hexamethyldisiloxane (HMDSO:(CH₃)₃Si-O-Si(CH₃)₃), octamethylcyclotetrasiloxane (OMCTS:((CH₃)₂)₄Si₄O₄ (Chemical formula 1)) and tetramethylcyclotetrasiloxane (TMCTS:(CH₃H)₄Si₄O₄ (Chemical formula 2)).

8. A semiconductor device manufacturing method according to claim 6, wherein methylsilane (SiHₙ(CH₃)₄₋ₙ: n=0, 1, 2, 3) is formed of any one of monomethylsilane (SiH₃(CH₃)), dimethylsilane (SiH₂(CH₃)₂), trimethylsilane (SiH(CH₃)₃) and tetramethylsilane (Si(CH₃)₄).

9. A semiconductor device manufacturing method according to claim 4, wherein the first barrier insulating film (34aa, 38aa) is an insulating film containing silicon, oxygen, nitrogen, hydrogen and carbon, and the first film forming gas contains at least any one of siloxane and methylsilane (SiHₙ(CH₃)₄₋ₙ:n=0, 1, 2, 3), and at least any one of N₂ and NH₃.

10. A semiconductor device manufacturing method according to claim 9, wherein siloxane is formed of any one of hexamethyldisiloxane (HMDSO:(CH₃)₃Si-O-Si(CH₃)₃), octamethylcyclotetrasiloxane (OMCTS:((CH₃)₂)₄Si₄O₄ (Chemical formula 1)) and tetramethylcyclotetrasiloxane (TMCTS:(CH₃H)₄Si₄O₄ (Chemical formula 2)).

11. A semiconductor device manufacturing method according to claim 9, wherein methylsilane (SiHₙ(CH₃)₄₋ₙ: n=0, 1, 2, 3) is formed of any one of monomethylsilane (SiH₃(CH₃)), dimethylsilane (SiH₂(CH₃)₂), trimethylsilane (SiH(CH₃)₃) and tetramethylsilane (Si(CH₃)₄).

12. A semiconductor device manufacturing method according to claim 4, wherein the second barrier insulating film (34ab, 38ab) is an insulating film containing silicon, oxygen and hydrogen, and the second film forming gas contains silane (SiH₄) and at least any one of N₂O and H₂O.

13. A semiconductor device manufacturing method according to claim 4, wherein the second barrier insulating film (34ab, 38ab) is an insulating film containing silicon, oxygen, hydrogen and carbon, and the second film forming gas contains at least any one of siloxane and methylsilane (SiHₙ(CH₃)₄₋ₙ:n=0, 1, 2, 3), and at least any one of N₂O, H₂O and CO₂.

14. A semiconductor device manufacturing method according to claim 13, wherein siloxane is formed of any one of hexamethyldisiloxane (HMDSO:(CH₃)₃Si-O-Si(CH₃)₃), octamethylcyclotetrasiloxane (OMCTS: ((CH₃)₂)₄Si₄O₄ (Chemical formula 1)) and tetramethylcyclotetrasiloxane (TMCTS:(CH₃H)₄Si₄O₄ (Chemical formula 2)).

15. A semiconductor device manufacturing method according to claim 13, wherein methylsilane (SiHₙ(CH₃)₄₋ₙ: n=0, 1, 2, 3) is formed of any one of monomethylsilane (SiH₃(CH₃)), dimethylsilane (SiH₂(CH₃)₂), trimethylsilane (SiH(CH₃)₃) and tetramethylsilane (Si(CH₃)₄).

16. A semiconductor device manufacturing method according to claim 4, further comprising the step of removing an oxide film on a surface of the copper film (33b, 38b) by exposing a surface of the copper film (33b, 38b) to a plasma of an NH₃ gas before the barrier insulating film (34a, 38a) is formed.

17. A semiconductor device manufacturing method according to claim 4, further comprising the step of forming an insulating film (34b) having a low dielectric constant on the barrier insulating film (34a).

18. A semiconductor device manufacturing method according to claim 17, wherein the wiring (37) made of the copper film (37b) or consisting mainly of the copper film (37b) is formed on the insulating film (34b) having the low dielectric constant.
